# EUROPEAN PATENT SPECIFICATION

(11) **EP 0 756 335 B1**
(45) Date of publication and mention of the grant of the patent: **12.04.2000**
(21) Application number: 96305357.4
(22) Date of filing: 22.07.1996
(51) Int. Cl.: H01L 39/22

(54) **Josephson device**
Josephson-Anordnung
Dispositif Josephson

(30) Priority: 24.07.1995 JP 20900595
(43) Date of publication of application: 29.01.1997
(73) Proprietor: INTERNATIONAL SUPERCONDUCTIVITY TECHNOLOGY CENTER, Tokyo (JP)
(72) Inventor: Konishi, Masaya, Yao-shi, Osaka, 581 (JP); Matsunaga, Yoshinori, Nara-shi, Nara-ken, 630 (JP); Enomoto, Youichi, Nerima-ku, Tokyo, 179 (JP); Tanaka, Shoji, Shinjuku-ku, Tokyo, 169 (JP)
(74) Representative: Smith, Norman Ian

(56) References cited:
- EP-A- 0 546 904
- EP-A- 0 557 207
- PATENT ABSTRACTS OF JAPAN vol. 017, no. 466 (E-1421), 25 August 1993 & JP-A-05 110151 (NIPPONDENSO CO LTD), 30 April 1993
- PATENT ABSTRACTS OF JAPAN vol. 017, no. 152 (E-1340), 25 March 1993 & JP-A-04 318983 (RIKEN CORP;OTHERS: 03), 10 November 1992
- PATENT ABSTRACTS OF JAPAN vol. 017, no. 152 (E-1340), 25 March 1993 & JP-A-04 318984 (RIKEN CORP;OTHERS: 03), 10 November 1992

## Description

This invention relates to a Josephson device which is utilized for high speed superconductive circuits, high-sensitivity magnetic sensors and so forth, in particular, to a novel grain boundary of a Josephson device of making use of a YBa₂Cu₃O₇₋ₓ (abbreviated as YBCO) as a superconductor. Here the number x of the oxygen deficiency from seven is restricted within a scope of 0≦x≦0.6. The value "x" in the scope makes YBa₂Cu₃O₇₋ₓ superconductive. Beyond the scope of x, YBa₂Cu₃O₇₋ₓ is normal-conductive. Hereinafter "x" takes a value within the scope 0≦x≦0.6. The representation of the scope will be omitted for simplicity.

This application claims the priority of Japanese Patent Application No.7-209005(209005/'95) filed on July 24, 1995.

Investigators have proposed and tentatively produced various types of Josephson devices using oxide superconductors. Big single crystals of oxide superconductors, however, could not be made yet by the current technology of crystal growth until recently. These investigators used to grow thin films of oxide superconductor on some non-superconductor single crystal substrates and to make necessary junctions on the oxide thin film. For example, a magnesium oxide (MgO) single crystal, a strontium titanate (SrTiO₃) monocrystal or so has been used as a substrate on which an oxide superconductor film is deposited for making Josephson junctions. There are various Josephson junctions according to the difference of producing the junctions. Josephson junctions can, however, be classified, in general, into grain boundary junctions, bridging junctions, edge junctions and layered junctions.

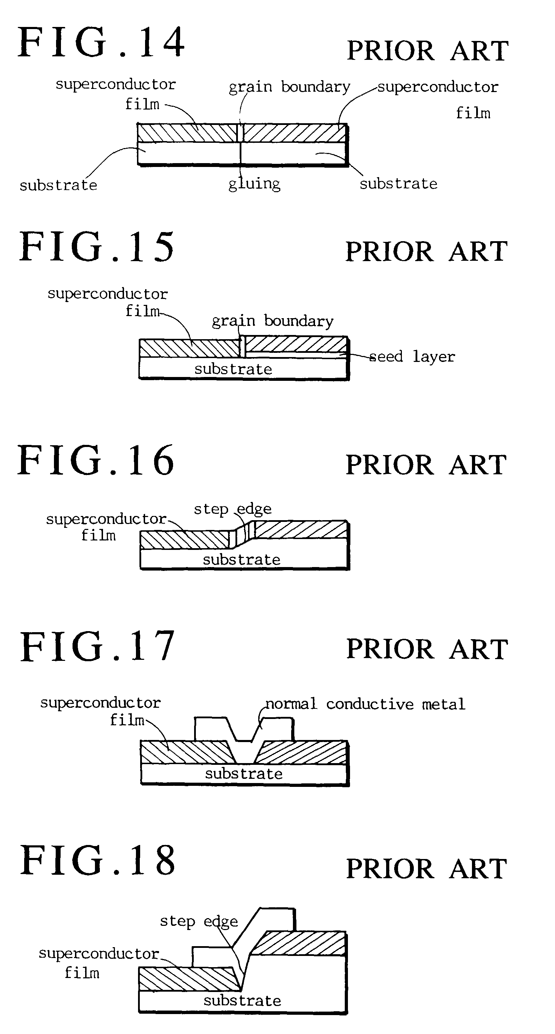

The grain boundary junction is a junction making use of the grain boundaries of superconductor films which are generated by making steps on a substrate or gluing crystals. The edge junction and the layered junction are junctions having a quite thin barrier layer between superconductive films. Prior Josephson junctions are explained by referring to Fig.14 to Fig.21. The expression of the number of atoms is omitted for simplicity hereinafter.

Fig.14 shows one type of the grain boundary junctions which is produced by gluing two substrates with different orientations, annealing the glued substrates and making a superconductor film on the glued substrates. The grain boundary appears in the film just above the gluing line of the substrates. This grain boundary can be utilized as a Josephson junction. The direction of current flow is parallel to the surface of the film. Since this junction is built with two crystals, the grain boundary junction is called a bicrystal junction of the grain boundary type. The substrates are suitably made from strontium titanate (SrTiO₃), magnesium oxide (MgO) or yttrium-stabilized zirconium oxide (YSZ).

Fig.15 shows another type of grain boundary junction which is made by depositing a seed layer on a part of a substrate, growing a superconductor film on the substrate and the seed epitaxially. Two films with different orientations are grown on the substrate and the seed. The end of the seed becomes a grain boundary. A Josephson junction can be made on the grain boundary. For example, a report says that a Josephson junction has been made by depositing a seed layer MgO partially on an Al₂O₃ monocrystal substrate and growing a YBCO thin film. This type is called a "biepitaxial junction", since the junction is based upon two epitaxial layers.

Fig.16 shows an example of the step edge junction which is produced by making a step edge on a substrate and growing a thin film on the substrate. The step edge causes a grain boundary. The grain boundary can be made good use of as a Josephson junction. This was reported, for example, by T. Mitsuzuka, K. Yamaguchi, S. Yoshikawa, K. Hayashi, M. Konishi and Y. Enomoto, "The microstructure and I-V characteristics of step-edge Josephson junctions in YBa₂Cu₃O₇ films on MgO (100) steps", Physica C 218, p229-237 (1993). The orientation of the crystal curves at the step edge. The curved orientation causes a grain boundary at the step edge.

All the above are proposals for making grain boundaries. In any cases, grain boundary junctions are made by introducing a local anomaly into a monocrystal for disturbing the periodicity of crystal structure. The grain boundary junction suffers from two drawbacks. One is the fact that the location of the junction is determined by the position of the local anomaly produced by some means. It is impossible to choose the location of junction freely after the process. The other weak point is that electric currents flow in parallel to the surface. The poor selectivity of location and the horizontal current flow are the weaknesses of the grain boundary junctions.

For seeking other type of junctions, someone tried to make a planar discontinuity of crystallography in a YBCO thin film and to measure the electron transportation across the discontinuity. For example, the planar grain boundary junction was proposed by D. J. Lew, Y. Suzuki, A. F. Marshall, T. H. Geballe, and M. R. Beasley, "Transport through 90° [010] basal-plane-faced tilt and twist grain boundaries in YBa₂Cu₃O_{7-δ} thin films", Appl. Phys. Lett. 65(12). p1584 (1994).
They made a planar discontinuity of crystal in parallel with the surface and concluded the grain boundary is improper for a Josephson junction.

Fig.17 shows a bridging junction which is produced by depositing a superconductor film on a substrate, cutting a groove on the superconductor film by the FIB (focus ion beam) method, filling the groove with gold (Au) and making an Au stripe on the junction. The junction works as an SNS junction, since two superconducting films sandwich the normal-conduction metal(Au). The bridging junction is named after the shape of the normal-conduction metal (Au) bridging the superconductor films.

Fig.18 shows another step-edge junction which is produced by eliminating a part of a substrate, making a step edge on the substrate, depositing a thin film of superconductor on the substrate and forming a golden stripe on the edge. This junction makes an SNS (super-normal-super) type junction which is one of step-edge types.

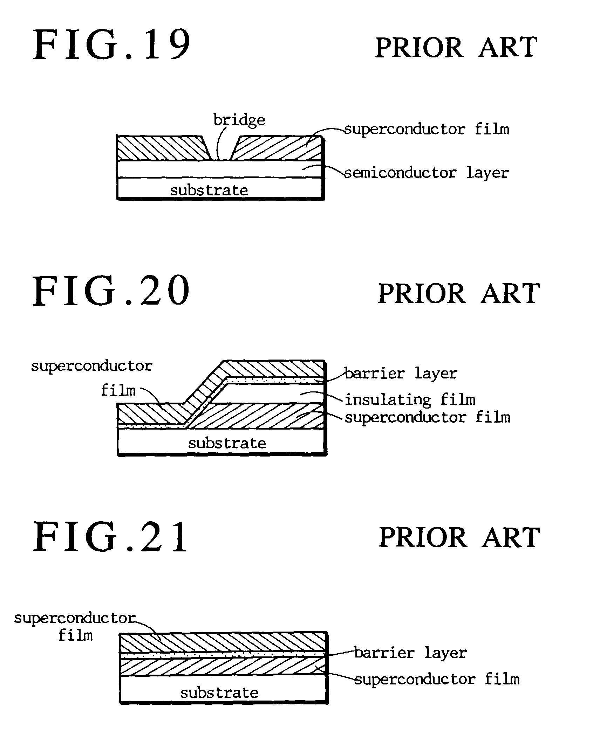

Fig.19 is a section of another bridging junction which is made by depositing a semiconductor film (LaBaCuO or PrBaCuO ; ; (LaBa₂Cu₃O₇, PrBa₂Cu₃O₇)) on a substrate, making a superconductor (HoBaCuO) film on the semiconductor and cutting a groove on the superconducting film. The part of the semiconductor below the groove acts as a bridge junction.

Fig.20 denotes another step-edge junction which is made by depositing a superconducting film on a substrate, covering the superconductor with an insulating film, eliminating a half part of the insulating film and the superconductor film, covering the step-edged crystal with a thin barrier layer and depositing a superconductor film. The superconducting film is made of e.g., YBa₂Cu₃O₇₋ₓ. The barrier layer is made of, for example, damaged YBCO, PrBaCuO or Nb-doped SrTiO₃. Two superconducting films face with each other via a thin barrier layer. This is one of step-edge junctions.

Fig.21 shows an example of layered junctions. The layered junctions are made by forming a planar SIS (superconductor-insulator-superconductor) or SNS (superconductor-normal-superconductor) structure. The intermediate normal conductive or insulating material acts as a barrier. The barrier layer is made with e.g., SrTiO₃. A layered junction is made by producing a superconductor film on a substrate, depositing a barrier layer on the superconductor and producing a superconductor film on the barrier layer. PrBaCuO should preferably be chosen as a barrier layer, when YBCO is the superconductor films. The material of the barrier layer is contingent upon the material of the superconductor. The layered junction has advantages of the whole area junction (a planar junction) and the vertical electric current flow. The layered junction still suffers from two drawbacks of a low critical Josephson current and a large fluctuation of the properties caused by the dispersion of the thickness of the barrier layer.

These junctions have inherent advantages and disadvantages. The junctions making use of grain boundary require the preparatory process of making small step edges or scars on the surface of the substrate. It is, however, very difficult to make the edges or scars at the same position with the same side with high reproductivity. It requires much time and money to give the same scars and the same steps to all the individual devices. The junctions basing upon the edge junctions or layered junctions must pile at least three different layers, i.e., the lower superconductor layer, the barrier layer and the upper superconductor layer on a substrate. Too many layers cause difficulties of producing the junctions. It is also difficult to make a ultrathin barrier layer with sufficient uniformity and high reproductivity.

This invention aims at an improvement of the grain boundary junction of the oxide superconductor YBa₂Cu₃O₇₋ₓ. Here, the scope of x (oxygen deficiency from 7) is 0≦x≦0.6, which ensures YBa₂Cu₃O₇₋ₓ to be a superconductor.

Prior grain boundary junctions demand some preparatory processes of making scars or step edges on which the junction will be formed. The problem is the fact that the preparatory steps lack sufficient reproductivity. Large fluctuation of the location, depth, width or direction of the scars or steps impairs the reproductivity and reliability of the grain boundary junctions.

One purpose of the present invention is to provide a method of making a grain boundary junction without the preparatory steps of making scars or step edges. Another purpose of the present invention is to provide a method of making a grain boundary junction by a small number of steps without piling a plenty of layers. Another purpose of the present invention is to provide a Josephson junction of high stability of properties. Another object of the present invention is to provide a method of making a Josephson device at an arbitrary location on a thin film without being restricted by the preparatory steps. The further object of the present invention is to provide a method of making a Josephson device which is immune from the influence of the fluctuation of the thickness of the layers.

To achieve the foregoing objects and in accordance with the purpose of the invention, embodiments will be broadly described herein.

According to one aspect of the present invention there is provided a Josephson device comprising: a YBa₂Cu₃O₇₋ₓ(001)(0≦X≦0.6) c-axis single crystal substrate which contains no material except YBa₂Cu₃O₇₋ₓ; a YBa₂Cu₃O₇₋ₓ a-axis orientated single crystal thin film (2) deposited on the single crystal substrate, wherein(0≤X≤0.6), a grain boundary formed at the interface between the substrate and the thin film; an electrode formed on the thin film and; an electrode (6) formed on the substrate.

According to a further aspect of the present invention there is provided a method of producing a Josephson device comprising of: preparing a YBa₂Cu₃O₇₋ₓ(001)(0≦X≦0.6) c-axis oriented single crystal substrate; heating the substrate up to 500°C to 680°C in vacuum; depositing a thin YBa₂Cu₃O₇₋ₓ(001)(0≦X≦0.6) a-axis oriented single crystal thin film on the heated single crystal substrate by a magnetron sputtering method such that a grain boundary is formed at the interface between the substrate and thin film; forming an electrode on the thin film and; forming an electrode on the substrate.

This invention proposes a new Josephson device belonging to the category of grain boundary junctions. All the prior grain boundary methods used to produce grain boundaries by making steps or scars on the substrate as the preliminary process. The present invention denies such a preliminary processing. Without the processing on the substrate, grain boundaries will be yielded by the present invention with a different method. How does this invention produce grain boundaries on a superconductor film? This is one of the most important problems. The present invention makes a grain boundary by the steps of preparing a (001) YBa₂Cu₃O₇₋ₓ single crystal substrate wherein 0 ≤ X ≤ 0.6, heating the YBCO substrate up to 500°C to 680°C in vacuum and depositing a YBa₂Cu₃O₇₋ₓ thin film on the heated (001) YBa₂Cu₃O₇₋ₓ substrate by an RF(radio-frequency)-magnetron sputtering. This is not an epitaxial growth at all which equalizes the orientation of the film to the substrate. The orientation of the film is different from the orientation of the substrate. The sputtering makes a YBCO film whose c-axis is orthogonal to the c-axis of the substrate YBCO. The c-axis is vertical to the surface in the (001) substrate. But the c-axis is parallel with the surface in the piled YBCO film. The discontinuity of the crystal orientations causes a new grain boundary at the interface between the substrate and the film. The grain boundary is parallel with the surface. This invention makes good use of the new grain boundary as a Josephson junction.

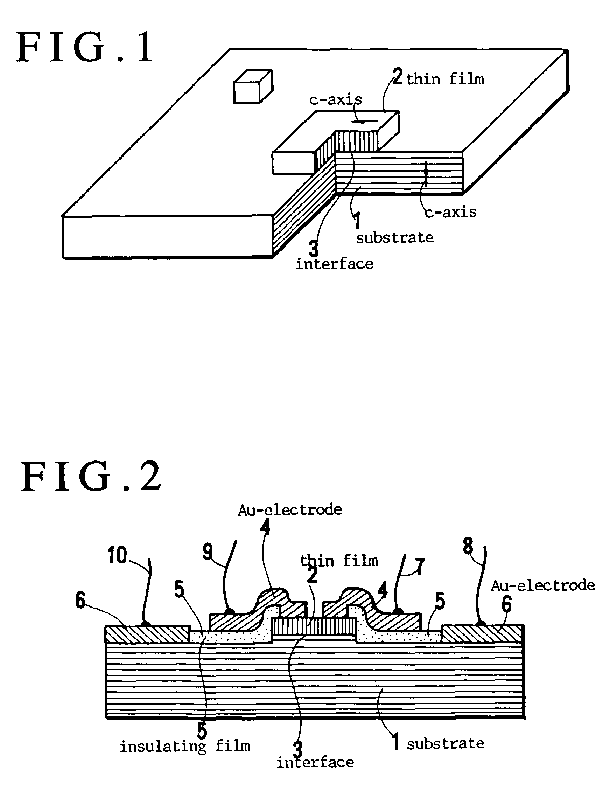

Fig.1 is a partially sectioned, perspective view of a substrate and a film of the invention for explaining the relation of the orientations of the substrate and the film. The substrate (1) is a single crystal of YBa₂Cu₃O₇₋ₓ whose c-axis is perpendicular to the surface. The parallel lines denote ab-planes which are parallel with the surface. A thin film (2) of YBa₂Cu₃O₇₋ₓ is grown on the YBCO substrate (1). The c-axis of the film (2) is parallel to the surface. The ab-planes of the film (2) are orthogonal to the surface. Namely, the c-axis of the substrate (1) is vertical to the c-axis of the film (2). The ab-planes of the film (2) meet at a right angle with the ab-planes of the substrate (1). This is a surprising fact induced by the magnetron sputtering on the (001) YBCO substrate. A grain boundary is caused at the interface (3) between the film (2) and the substrate (1) by the difference of the orientations. The interface (3) becomes a grain boundary. This invention makes the best use of the grain boundary as a Josephson junction for producing a new Josephson device.

It is very difficult to make a large single crystal oxide superconductor. It was quite impossible to grow a large monocrystal oxide superconductor until quite recently. All the prior Josephson devices which have been explained before used to pile a thin film of oxide superconductor on a non-superconductor substrate, for example, on a MgO single crystal substrate or a SrTiO₃ monocrystal substrate, because they could not make a big monocrystal superconductor substrate.

Recently, the state of art has attained at a level capable of making a wide oxide superconductor monocrystal. Such a wide superconductor crystal can now be used as a substrate, which is a great progress of the technology of growing crystals.

The purpose of employing a single crystal as a substrate is, in general, to grow films epitaxially on the single crystal substrate. "Epitaxial" means that the orientation of the films coincides with the orientation of the substrate with the common crystallographical axes. When the material of the film is the same as the material of the substrate, the film is liable to grow epitaxially on the substrate. Even when a film of a different material is deposited on a single crystal substrate, the film sometimes becomes epitaxial, if the lattice constant of the film material is close enough to the lattice constant of the substrate. This is sometimes called "heteroepitaxy". In usual, a single crystal is employed as a substrate for growing films epitaxially under a contrived condition in order to regulate the orientation of the growing films.

The principle of epitaxy would probably be applicable to oxide superconductor crystals. It would be expected that a film would be epitaxially grown on a superconductor substrate, if a single crystal superconductor were used as a substrate. The fact has not been proved until recently, because no big single crystal superconductor available for a substrate has been produced.

Now the current technology can make a sufficiently wide single crystal of oxide superconductor which enables us to examine the relation of the orientations of the substrate and the film. Experiments show that a single crystal superconductor substrate allows superconductor films to grow with the same orientations in many cases. Namely, the experiments verify an occurrence of the epitaxial growth of films on a single crystal superconductor. No boundaries originate at the interface between the film and the substrate. The lattices are neatly aligned at the interface also in the epitaxial growth of the oxide superconductors.

Challenging the common sense, the Inventors have a new idea of making use of "non-epitaxial growth" of the same material for making a grain boundary. "Non-epitaxial" growth, here, means that a film of material A grows in a different orientation on a substrate of the same material A. Namely, the film and the substrate are common in material. But the orientations are different in the substrate and the film in the non-epitaxy. Then, the difference of the orientations would induce a grain boundary at the interface between the film and the substrate. The non-epitaxy does not require only the existence of the misalignment between the film and the substrate but also the single crystal of the film. If the film were to be polycrystal, a lot of grains would be generated in whole the film. Such grains would be insignificant for forming a Josephson junction, because the polycrystal film could not act as a superconductor. The non-epitaxy at which this invention aims requires that the film and the substrate are single-crystal of the same material but the orientations are different for generating the grain boundary only at the interface.

Nobody has perhaps attempted such a trial of the non-epitaxial growth. The epitaxial growth has been an ideal of crystal growth hitherto. In practice, if a film is grown on a substrate of the same material, the film usually becomes a single crystal with the same orientations and the same axes as the substrate. The Inventors have attempted various trials aiming at non-epitaxy for inviting grain boundaries.

The Inventors have grown a YBa₂Cu₃O₇₋ₓ film on a YBa₂Cu₃O₇₋ₓ substrate by a RF-magnetron sputtering method on various different conditions. In many cases, the films epitaxially grow in the same orientation as the substrate. The Inventors have discovered that some restricted condition allows a film to grow non-epitaxially on the substrate of the same material. The discovery of the existence of the non-epitaxial growth is the key point of the present invention.

The Inventors prepared a (001) sufficiently large YBa₂Cu₃O₇₋ₓ single crystal as a substrate. (001) means that the c-axis is vertical to the surface. Then, the substrate was heated to 500°C to 680°C in vacuum. Then a YBa₂Cu₃O₇₋ₓ film was grown on the heated single crystal YBCO substrate by an magnetron sputtering method. The result was surprising. The film was a single crystal having the c-axis parallel with the surface. This is an astounding fact.

Oxide superconductors have not cubic symmetry in many cases. Cubic symmetry means that a=b=c and α = β = γ =90 degrees, where a, b and c are the axis lengths of a unit cell and α, β and γ are the angles between the axes. Of course, YBa₂Cu₃O₇₋ₓ is not a cubic crystal. The a-axis is similar to the b-axis. The c-axis is longer than the a-axis and the b-axis. The crystal YBa₂Cu₃O₇₋ₓ has the orthorhombic symmetry(a≒b≠c , α = β = γ = 90 degrees). Since the a-axis is akin to the b-axis, b-axis is not often discriminated from the a-axis. In the case, "a-axis" includes the a-axis and the b-axis in the strict meaning. The a-axis and the b-axis are symmetric axes. The c-axis, however, is an asymmetric axis which is conspicuously different from the a-axis or the b-axis.

In the case abovementioned, since the substrate is a (001) crystal which has the c-axis perpendicular to the surface, it may be expected that a film would grow in the direction of the c-axis following the orientation of the substrate, because the film has the same lattice constant and the same crystallographical symmetry. However, a magnetron sputtering can grow a (100) YBCO single crystal film on a (001) YBCO substrate under a restricted scope of the substrate temperature. This is a surprising fact beyond the common sense of the technology of crystal growth. A (100) crystal means that the a-axis is perpendicular to the surface of the film. The film is a single crystal of orthorhombic symmetry with the a-axis which is a normal to the surface. Some scope of the substrate temperature enables the magnetron sputtering to deposit a (100) YBa₂Cu₃O₇₋ₓ single crystal film on a (001) YBa₂Cu₃O₇₋ₓ single crystal substrate. This is a non-epitaxial growth of a film on the same material.

The lattice structure becomes discontinuous at the interface between the substrate and the film due to the difference of the orientations. The discontinuity of the lattice structure generates the crystal grain boundary at the interface between the film and the substrate. The superconductivity is weaker at the region of the grain boundary than in the other parts, since the fluctuation of the lattice structure impedes the carrier transportation in the superconductive state. This invention makes the best use of the part having a weak superconductivity due to the lattice discontinuity for producing a Josephson junction. The Josephson junction of the present invention is the grain boundary produced by the discontinuity caused by the non-epitaxial growth of the film on the same material substrate.

Advantages of the present invention are explained in comparison with prior art. A Josephson device in the layered junction requires an intermediate layer of an insulator, a semiconductor or a normal conductive metal between two superconductors. The intermediate layer makes an SIS or an SNS junction. As explained before, Josephson junctions, in general, are produced by utilizing three kinds of junctions, i.e., a grain boundary junction, a step edge junction or a layered junction.

The step edge junction or the layered junction sandwiches a thin barrier layer between a substrate and a film. The material of the barrier layer is different from the material of the substrate and the film which is a superconducting material.

The barrier layer junction suffers from drawbacks of the existence of an extra step of making a barrier layer, the difficulty of making a uniform, thin barrier layer and the difficulty of making a single crystal of the thin film on the barrier.

The prior grain boundary junctions require the process of making steps or scars on a substrate. It is, however, a difficult and time-consuming process. Further, it is hard to execute the process of making steps or scars with high reproductivity.

On the contrary, this invention can build a Josephson junction only by making a thin film of the same material superconductor on a single crystal superconductor substrate. The junction is parallel to the surface. Thus, a current flows in the direction vertical to the surface, which is convenient for designing a Josephson device. This invention dispenses with the intermediate barrier layers or the intermediate seed layer, because the present invention makes a grain boundary by the sharp difference of orientations. Elimination of the intermediate layer simplifies the process of production.

The substrate crystal itself is a superconductor. There is no substrate of a non-superconductor unlike the prior ones of Fig.14 to Fig.21. The process of piling a superconductive film on a non-superconductive substrate is eliminated. Another merit is a good crystallographical property of the superconductive substrate. Heteroepitaxy used to impair the lattice structure of a superconductive film grown on a MgO or a SrTiO₃ substrate. The electrode can be attached on either the top surface or the bottom surface of the superconductive substrate.

The present invention exploits the anisotropic junction borne by the non-epitaxy for yielding a planar grain boundary without the step edges or the scars. The present invention is superior to the prior junctions in the simplicity of the process, the high reproductivity, the high freedom of designing and the direction of the current.

The invention will be more fully understood from the following description given by way of example only with reference to the several figures of the accompanying drawings in which;

Fig.1 is a partially-sectioned, perspective view of a superconductor substrate and a superconductor film for showing the orientations of the film and the substrate produced by this invention.

Fig.2 is a sectional view of a Josephson device of an embodiment of the present invention.

Fig.3 is a sectional view of a (001) YBa₂Cu₃O₇₋ₓ single crystal substrate and a YBa₂Cu₃O₇₋ₓ single crystal film having a c-axis parallel with the surface deposited on the substrate by a magnetron sputtering method according to the teaching of the present invention.

Fig.4 is a sectioned view of the substrate and the film after the step of eliminating the upper surface by etching except a part of 40 µm square.

Fig.5 is a graph showing the X-ray power diffracted in the direction of 2θ from the YBCO film specimen which has been produced by the magnetron sputtering at a substrate temperature of 760°C for incident angles χ of 56.3 degrees and 33.7 degrees.

Fig.6 is a graph showing the X-ray power diffracted in the direction of 2θ from the YBCO film specimen which has been made by the magnetron sputtering method at a substrate temperature of 630 °C for incident angles χ of 56.3 degrees and 33.7 degrees.

Fig.7 is a sectional view for explaining that a (102) plane of a film crystal having a c-axis perpendicular to the surface meets with the surface at an angle of 56.3 degrees.

Fig.8 is a sectional view for explaining that a (102) plane of a film crystal having a c-axis parallel with the surface meets with the surface at an angle of 33.7 degrees.

Fig.9 is a graph showing the relation between an applied voltage (µV) and the current (mA) of the Josephson device of an embodiment of the present invention.

Fig.10 is graph showing the relation between an applied voltage (µV) and the current (mA) of the Josephson device of an embodiment irradiated by microwave.

Fig.11 is a TEM photograph of the junction of the Josephson device of the embodiment of the present invention.

Fig.12 is a schematic view of a unit cell of YBa₂Cu₃O₇₋ₓ crystal. A black round means a Cu atom. A double round is a Ba atom. A blank round is a Y (yttrium) atom. The c-axis is the longest axis. The a-axis and the b-axis are shorter axes.

Fig.13 is a schematic view of crystal structure showing the behavior of the crystal growing in an orientation of the c-axis parallel with the surface on the substrate having the c-axis vertical to the surface.

Fig. 14 is an explanatory sectional view of a prior grain boundary junction produced by gluing two non-superconductive substrates and growing a superconductor thin film on the substrate. A grain boundary is formed in the film just on the juncture in the horizontal direction.

Fig.15 is an explanatory sectional view of another prior grain boundary junction produced by coating a part of a non-superconductor substrate with a seed layer, depositing whole the surface with a superconductor film and making a grain boundary at the end of the seed layer. A horizontal junction is formed between two divided halves of the superconductors.

Fig.16 is an explanatory sectional view of another prior grain boundary junction produced by eliminating a part of a non-superconductor substrate, making a step edge between the eliminated part and the rest and inducing grains at the step edge.

Fig.17 is an explanatory sectional view of a prior edge junction formed by producing a superconductor thin film on a substrate, dividing the superconductor film into two halves by cutting a groove on the film and filling the groove with a normal conductive metal. The edge of the normal conductive metal makes an SNS junction.

Fig.18 is an explanatory sectional view of another prior edge junction prepared by eliminating a part of the substrate, forming a thin film on the stepped substrate, filling the uncovered portion at the edge with a normal conductive metal. The normal conductive metal makes an SNS junction.

Fig.19 is an explanatory sectional view of another prior edge junction produced by depositing a semiconductor film on a non-superconductor substrate, growing a superconductor film on the semiconductor film and dividing the superconductor film into two halves by cutting a groove.

Fig.20 is an explanatory sectional view of another prior edge junction made by piling a superconductor film and an insulating film on a non-superconductive substrate, eliminating a part of the films for making a step edge at the periphery of the eliminated part, forming a barrier layer on whole the surface and depositing a superconductor film. A junction is made in the horizontal direction between the two superconductor films.

Fig.21 is an explanatory sectional view of a prior layered junction prepared by piling a superconductor film on a non-superconductive substrate, depositing a barrier layer on the superconductive film and piling another superconductor film on the barrier layer which becomes a Josephson junction. The current flows vertical to the surface.

Fig.22(1) is a graph showing a typical relation between the current and the voltage of an ideal Josephson junction without microwave.

Fig.22(2) is a graph showing a typical relation between the current and the voltage of an ideal Josephson junction when microwave irradiates the specimen.

Fig.2 shows a section of a Josephson device as an embodiment of the present invention. A substrate (1) is a (001) YBa₂Cu₃O₇₋ₓ single crystal. Namely, the c-axis is vertical to the surface. A YBa₂Cu₃O₇₋ₓ single crystal thin film (2) is formed at the center of the substrate (1). The c-axis of the thin film (2) is parallel with the surface. Thus, the c-axis of the film is orthogonal to the c-axis of the substrate. The difference of the orientations of two crystals causes a grain boundary at the interface (3) between the substrate (1) and the film (2). This invention positively makes use of the grain boundary as a Josephson junction.

An insulating film (5) which is deposited around the film (2) covers the substrate (1) except the periphery. An Au electrode (4) is formed on the YBa₂Cu₃O₇₋ₓ thin film (2) and on a part of the insulating film (5). The Au electrode (4) makes an ohmic contact with the YBCO thin film (2). The peripheral part of the insulating film (5) is eliminated and other Au electrode (6) is formed on the revealed periphery of the substrate (1). A voltage-measuring terminal (7) and a current-leading terminal (9) are wirebonded on the film-electrode (4). Another voltage-measuring terminal (8) and another current-leading terminal (10) are wirebonded on the substrate-electrode (6). This is an embodiment of this invention. The Josephson device was made by the following processes.

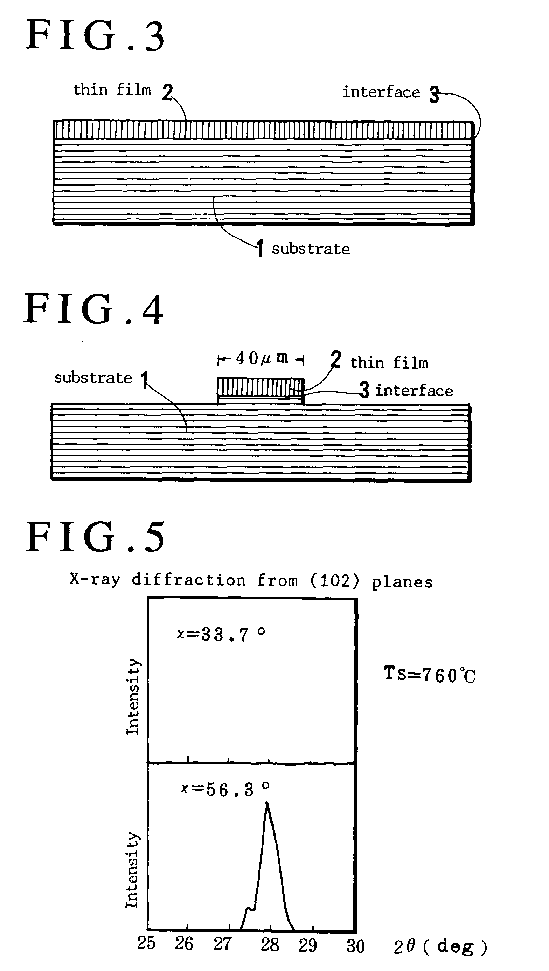

A substrate prepared was a (001) YBa₂Cu₃O₇₋ₓ single crystal plate having a thickness of 0.5mm. A YBa₂Cu₃O₇₋ₓ thin film was formed on the YBa₂Cu₃O₇₋ₓ substrate (1) kept at 630°C by a magnetron sputtering to a thickness of 200nm. Fig.3 denotes the state of the specimen after the film formation. The parallel lines show quasi-isotropic ab-planes. C-axes are vertical to the parallel lines. The c-axis of the substrate is perpendicular to the surface. The c-axis of the film is parallel with the surface. Then, the c-axis of the film (2) is orthogonal to the c-axis of the substrate (1).

The peripheral parts of the film (2) and the substrate (1) were selectively eliminated except a central square part of 40 µm by ordinary photolithography and etching. The rest, square of 40 µm, included a part of film, a part of interface and a protrusion of the substrate. Fig.4 denotes the sample after the etching. Then, an insulating film (5) was piled on the sample. Then the device shown in Fig.2 was produced by eliminating central and peripheral parts of the insulating film (5), forming Au electrodes on the revealed film and the revealed substrate and wirebonding the Au terminal wires (7), (8), (9) and (10). The four wires were required for measuring the voltage-current relation of the device by the four probe method.

The crystal property and the orientation of the specimen of Fig.3 were investigated by the X-ray diffraction method of 2θ - θ scanning. The X-ray measurement revealed the following facts.
① When the temperature of the substrate is higher than 680°C, the magnetron sputtering makes a YBa₂Cu₃O₇₋ₓ single crystal film of (001) orientation on a YBa₂Cu₃O₇₋ₓ (001) monocrystal substrate. The orientations are common. It is an ordinary epitaxial growth.
② When the substrate temperature is lower than 500°C, the YBa₂Cu₃O₇₋ₓ films made by the same magnetron sputtering are not crystalline but amorphous.
③ When the substrate is maintained at an intermediate temperature between 500°C and 680°C, the magnetron sputtering makes a YBa₂Cu₃O₇₋ₓ single crystal with a c-axis parallel to the surface on the YBa₂Cu₃O₇₋ₓ (001) single crystal substrate. The c-axes of the substrate and the film are orthogonal. This is the non-epitaxial growth which has never been known yet in the field of crystal growth of superconductors.

There are three different cases ①, ② and ③ depending on the temperature of the substrate.

In the case of ②, the RHEED gives no diffraction pattern of crystal. The substrate temperature is so low that the film cannot become a crystal.

The X-ray diffraction measurement also clarifies the case ①. Fig.5 is graphs of the intensity of the X-rays diffracted from (102) planes of the film which has been made on the YBCO substrate heated at 760°C by the magnetron sputtering, for the incident angels χ =33.7 degrees and χ =56.3 degrees. There is no diffracted X-rays from (102) planes for χ =33.7 degrees. By contrast, χ =56.3 degrees has a high peak of the diffracted X-rays at 2θ = 28 degrees.

The meaning of the X-ray diffraction is now explained. In a YBa₂Cu₃O₇₋ₓ crystal, (102) planes incline to (001) planes at 56.3 degrees. Since YBa₂Cu₃O₇₋ₓ makes an orthorhombic crystal with the axes of different lengths, the angle between a (001) plane and a (102) plane of YBa₂Cu₃O₇₋ₓ crystal is different from the angle for a cubic crystal in which the corresponding angle between a (102) plane and a (001) plane is 64 degrees.

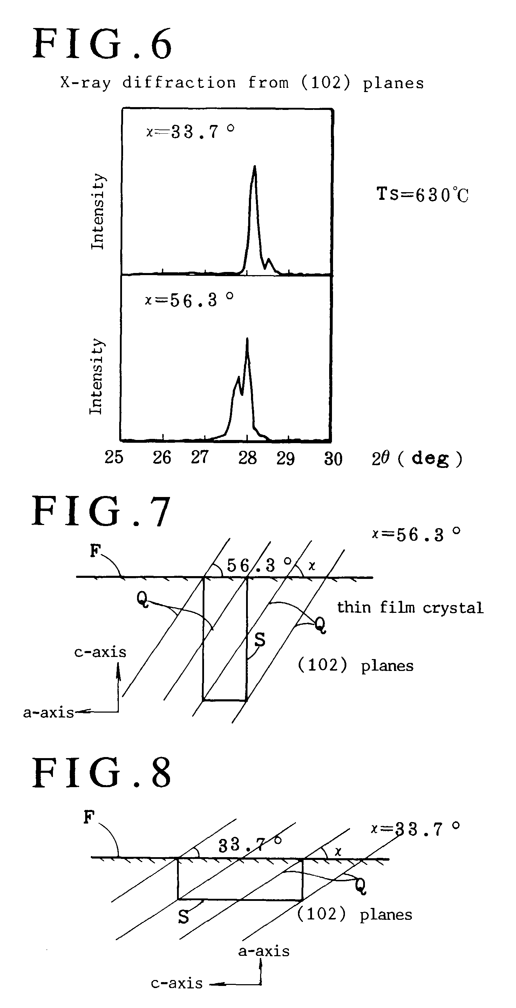

If the c-axis is normal to the surface, (102) planes are expressed by the parallel lines (Q) in Fig.7. In the figure, (F) is the surface, (S) is a unit cell and (Q) are a group of (102) planes. χ is the inclination angle of the specimen to the starting X-ray beam line. If the inclination angle χ is set to be 56.3 degrees at the beginning, the X-ray beams are perpendicular to (102) planes. The 2θ - θ X-ray measurement rotates the specimen by θ at the center and rotates the detector by 2θ around a circle from the starting angle θ =0. 2θ is a diffraction angle between the incident beams and the diffracted beams. The diffracted beams should make a peak at 2θ = 28 degrees from the (102) planes for the starting angle χ =56.3 degrees, if the c-axis of the film is vertical to the surface.

2θ =28 degrees is the angle which satisfies Bragg's condition 2dsin θ = λ for the spacing d of (102) planes, where λ is the wavelength of the X-rays, d is the spacing of equivalent planes, θ is the angle between the incident beams and the planes, θ is at the same time an angle between the planes and the diffracted beams and 2θ is the diffraction angle by the planes. Thus, the peak of 2θ =28 degrees means the X-ray diffraction from the (102) planes for any starting inclination χ. The 2θ =28° peak is equivalent to the diffraction from (102) planes.

Otherwise, if the c-axis of the thin film is parallel to the surface, the unit cell (S) is parallel to the surface, as shown in Fig.8. (102) planes incline at 33.7 degrees to the surface of the film. In this case, if the specimen is inclined at 33.7 degrees to the starting X-ray beam line, a peak of diffracted beams should appear at 2θ =28 degrees by the 2θ - θ measurement. The existence of a peak at 2θ = 28 degrees for χ =56.3 degrees means that the c-axis is perpendicular to the surface, as shown in Fig.7. Similarly, a peak at 2θ =28 degrees for χ =33.7 degrees signifies that the c-axis is parallel to the surface, as denoted by Fig.8.

Then, the sample film is investigated by the 2θ - θ scanning X-ray diffraction for the initial angles χ =56.3 degrees and χ =33.7 degrees.

As mentioned before, there is no 2θ =28° peak in the X-ray diffraction spectrum for χ =33.7 degrees from the YBCO film grown on a YBCO substrate heated at 760°C, as shown in Fig.5. There is only a 2θ = 28° peak in the diffraction spectrum for χ =56.3 degrees from the same film. The result signifies that the c-axis of the crystal is perpendicular to the surface, which is clarified by Fig.7. The peak originates partly from the film and partly from the substrate. The film has grown epitaxially on the substrate at 760°C. The film and the substrate are in ordinary epitaxial relation. Fig.5 means the epitaxial growth of a (001) YBCO film on the (001) YBCO substrate.

On the contrary, the sample which has a YBCO film grown on a (001) YBCO substrate at 630°C has the 2θ =28° peak both for χ =33.7 degrees and χ =56.3 degrees, as shown in Fig.6. The 2θ =28° peak of χ =56.3 degrees means the vertical c-axis of a crystal. The peak of χ =56.3 degrees attributes to the diffraction from the (001) YBCO substrate. The 2θ =28° peak of χ =33.7° means the existence of the horizontal c-axis of a crystal. The (001) substrate cannot make the 2θ =28° peak of χ = 33.7° , because the c-axis of the substrate is orthogonal to the surface. Thus the film must have c-axes in parallel with the surface. The film orientation is (100). This diffraction pattern having the 2θ = 28° peak for χ =33.7° corresponds to the case ③.

Fig.6 verifies the actual occurrence of the case ③ in which the film orientation is different from the substrate orientation. The present invention pays attention to the case ③ which induces discontinuity of lattice structures and the grain boundary at the interface due to the difference of orientations of the film and the substrate. This invention exploits the planar grain boundary which is novel in itself as a Josephson junction.

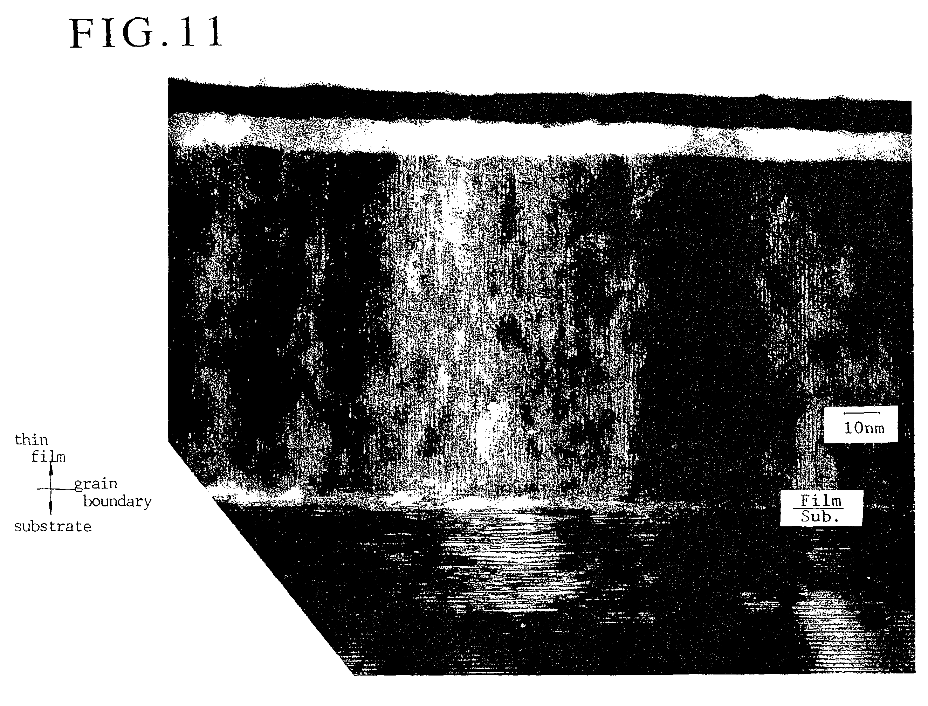

There is another direct evidence of the occurrence of the non-epitaxy (the case ③). Fig.11 is a TEM photograph of the section of a sample of YBa₂Cu₃O₇₋ₓ crystal which has been produced by heating a YBa₂Cu₃O₇₋ₓ (001) single crystal substrate at 580°C and piling a YBa₂Cu₃O₇₋ₓ film on the substrate by the magnetron sputtering. The (001) substrate has a plenty of horizontal lines which actually correspond to the quasi-isotropic ab-planes. The horizontally extending ab-planes signify that the c-axis is vertical to the surface in the (001) substrate.

The film has a lot of vertical lines of ab-planes to the contrary. The vertically extending ab-planes means that the c-axis of the film is parallel to the surface. The direction of ab-planes changes at the interface. The ab-planes of the film shoot the ab-planes of the substrate at a right angle. The sudden change of the orientation brings about a discontinuity of lattices which can be clearly observed at the interface. The discontinuity causes the grain boundary at the interface. The discontinuity needs neither barrier layers nor step edges. The grain boundary is horizontal. If the discontinuity at the interface is utilized as a Josephson junction, an electric current flows in a vertical direction across the horizontal junction.

The next problem is the reason of the occurrence of non-epitaxy. Why can a thin film with a different orientation grow on a orthorhombic (001) crystal substrate? It may be a common sense to suppose that a (001)-oriented film should be piled epitaxially on the (001) single crystal, because the material of the thin film is the same as the substrate. Some scope of the substrate temperature allows the magnetron sputtering to grow a thin film having a different c-axis on an orthorhombic (001) single crystal substrate. The Inventors suppose that the reason of the strange phenomenon is partly because the c-axis is about three times as long as the a-axis in a YBa₂Cu₃O₇₋ₓ crystal and partly because Ba atoms, Y atoms and Cu atoms are located in symmetric positions in a unit cell of YBa₂Cu₃O₇₋ₓ. Namely, c≒3a, where a is the length of an a-axis and c is the length of a c-axis.

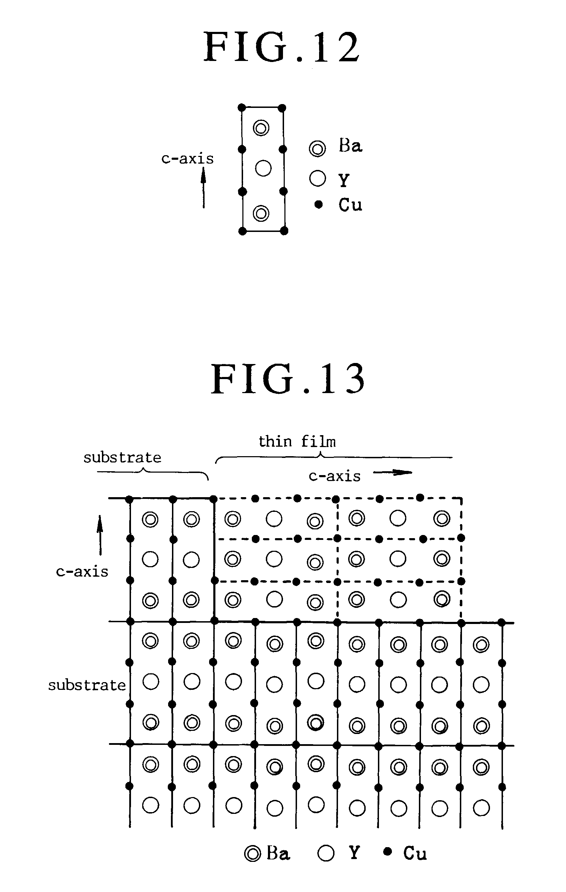

Fig.12 is a schematic structure of a unit cell of YBa₂Cu₃O₇₋ₓ crystal. Although the actual unit cell has a far more complex structure in a three dimensional space, the unit cell is simplified now for facilitating the understanding of the strangeness of the lattice. Black rounds are copper (Cu) atoms, a blank round means a yttrium (Y) atom and double-rounds denote barium (Ba) atoms. Oxygen atoms are neglected in the figure. A unit cell is a rectangular column. The unit cell is the longest in the direction of the c-axis. A c-axis is about three times as long as a-axis (or b-axis). Each one of the Ba atoms and Y atoms lies individually in a cubic skeleton built by Cu atoms.

Fig.13 shows a beginning state of atoms piling on a (001) YBa₂Cu₃O₇₋ₓ substrate. The substrate is constructed with an assembly of vertically longer cells having a c-axis orthogonal to the surface. Solid lines denote the outlines of unit cells. Ba atoms are located face to face in neighboring cells both in the c-direction and in the a-direction. The location of allowing the Ba-Ba pairing may reduce the free energy of the lattice.

There are steps of a height of a c-axis on the surface. When the magnetron sputtering brings active atoms or radicals to the surface of the substrate, the atoms would fill the steps, since the drop of the free energy is the biggest at the steps. There are two possible modes in filling the steps.

One mode is a vertical posture of a cell with a c-axis in a vertical direction, which is an epitaxial growth. The other mode is piling in a horizontal posture of a cell having a c-axis in a horizontal direction.

The latter mode can satisfy the requirement of pairing Ba-Ba in neighboring cells for reducing the free energy. Since c=3a, a pile of three horizontal cells levels the top of the piled cells with the top of the neighboring cell of the substrate. The coincidence of the height makes the top of the piled cells sufficiently flat. The equation c=3a allows copper atoms to occupy nearly the same locations both in the horizontal cells and in the vertical cells. The dotted lines show the latter mode of piling of the lattices. The relation c=3a and the symmetry of locations allows the latter mode of piling horizontal lattices to reduce the free energy. Thus, a certain range (500°C to 680°C) of the substrate temperature enables Ba, Y, Cu and O atoms to form such a horizontally-extending lattice structure as shown by the dotted lines in Fig.13. The special property of YBa₂Cu₃O₇₋ₓ realizes the latter mode of sputtering.

Of course, the first mode brings about the lowest free energy. If the substrate temperature is high enough (above 680°C) to forgive once adsorbed atoms to migrate to the points of the lowest energy, the first mode will be realized, which is an ordinary epitaxy. If the substrate temperature is too low (below 500°C) to allow the atoms to migrate, the film becomes amorphous. If the substrate temperature is intermediate (500°C to 680°C), once adsorbed atoms can migrate to the points of lower energy but cannot reach the lowest points due to the deficiency of thermal agitation. This may cause the latter mode of piling, i.e., non-epitaxy.

### [EMBODIMENT]

A YBa₂Cu₃O₇₋ₓ single crystal of (001) orientation is prepared for a substrate. The substrate is set on a susceptor in a chamber of a magnetron sputtering apparatus. The chamber is vacuumed and the substrate is heated up to 630°C via the susceptor. Then, a YBa₂Cu₃O₇₋ₓ thin film is grown on the (001) YBa₂Cu₃O₇₋ₓ substrate by magnetron sputtering.

The orientation of the specimen is investigated by the X-ray diffraction of 2 θ *-* θ scanning. The specimen having the film and the substrate gives a 2θ =28° peak for the starting inclination χ =56.3° ,which is smaller than the peak of Fig.5. The same specimen reveals a 2θ =28° peak also for the starting inclination χ =33.7°.

The existence of the 2θ =28° diffraction peak for χ = 33.7° signifies that the c-axis of the thin film is parallel to the surface, as explained before by referring to Fig.8. The other 2θ = 28° peak for χ = 56.3° must originates from the diffraction out of the (001) substrate. The measurement verifies that the thin film is a single crystal and the c-axis is parallel with the surface. Then, a Josephson device of Fig.2 is produced by making electrodes (4) and (6) and an insulating film (5) by evaporation and etching with photolithograpy on the substrate (1) and the film (2). Then, the four terminals are wirebonded on the electrodes (4) and (6).

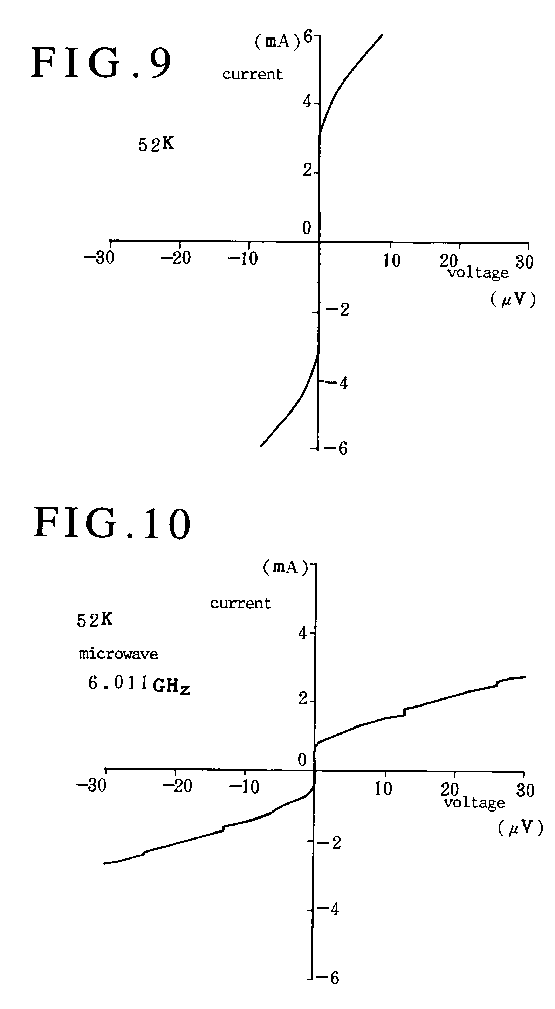

The appearing voltage between the film (2) and the substrate (1) is measured by flowing the current across the junction. Fig.9 shows the current-voltage characteristic at 52K (absolute temperature) without magnetic field (B=0). Without appearing voltage (V=0), 3mA of current flows across the junction. Namely, a superconductive current flows via the grain boundary junction. When the current increases beyond 3 mA, a certain voltage appears at the junction. The junction is no longer superconductive for |I| >3mA.

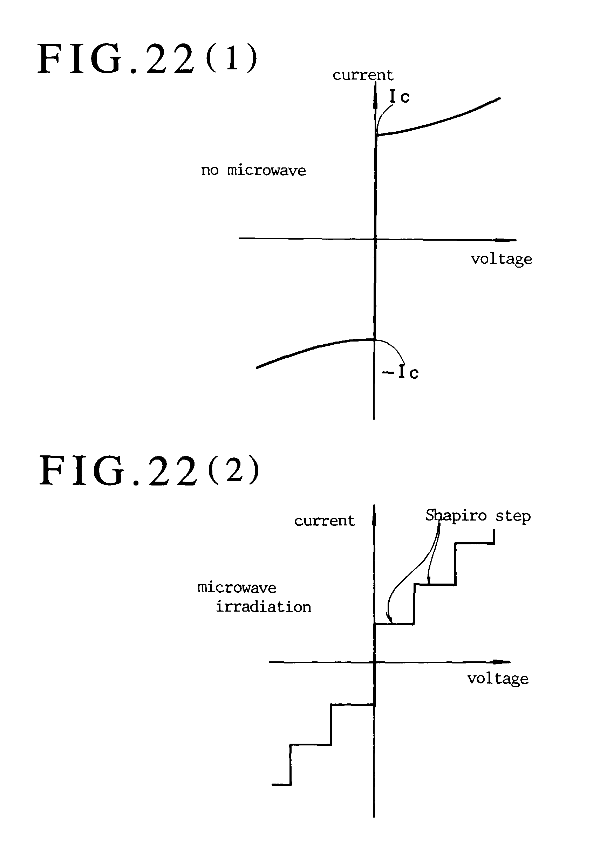

An ideal Josephson junction should reveal the current-voltage relation shown in Fig.22(1), when no magnetic field is applied. A superconductive current I which is smaller than Ic flows for V=0. When the current I increases over the critical current Ic, the voltage suddenly rises, which means a breakdown of superconductivity. The junction of the present invention rather induces a slow rise of voltage, when the current increases over 3 mA. The retardation of the rise of voltage is caused by inhomogeneity of the junction.

Fig.22(2) shows a voltage-current relation of an ideal Josephson junction, when microwave is applied. The magnetic field of the microwave suppresses the superconductive current (V=0). A certain amount of an increase of voltage induces a sudden increment of current. Namely, the current is enhanced stepwise as a function of voltage. The current is stepwisely in proportion to the voltage due to the quantumization of current and voltage by the magnetic field. The height of a step is a constant value of current. The width of a step is a constant value of voltage which is given by V=hf/2e=2.07×10⁻¹⁵f, where h is Plank's constant, e is a charge of an electron and f is frequency of the microwave. The steps of the current/voltage relation is called Shapiro's step. Whether the junction is a Josephson junction or not is examined by the existence of Shapiro's step in the voltage/current property under the irradiation of microwave.

Fig.10 is a result of current-voltage characteristic measured on the embodiment device of this invention, when the device is irradiated by the microwave of f=6.011 GHz. The influence of the microwave reduces the superconducting current from 3mA (B=0, in Fig.9) to 0.6 mA. The current jumps at ±13 µV and ±26 µV. The abovementioned equation V=2.07 × 10⁻¹⁵f gives 12.5 µV for the frequency f=6.011GHz. The measured value coincides with the calculated value of the step width of the current-voltage relation. This fact identifies the jumps at 13 µV and 26 µV with Shapiro steps. Since Shapiro steps appear in the current-voltage relation under an irradiation of microwave, the junction acts as a Josephson junction. The result confirms that the grain boundary made by the difference of orientations of crystals of the same material can be a Josephson junction. The current curve between the neighboring steps is not horizontal but slanting in the graph of Fig.10. The continuous increase of current between the steps may be attributed to the inhomogeneity of the junction.

## Claims

1. A Josephson device comprising:
a YBa₂Cu₃O₇₋ₓ(001)(0≦X≦0.6) c-axis single crystal substrate (1) which contains no material except YBa₂Cu₃O₇₋ₓ;
a YBa₂Cu₃O₇₋ₓ a-axis orientated single crystal thin film (2) deposited on the single crystal (001) substrate, wherein(0≤X≤0.6),
a grain boundary (3) formed at the interface between the substrate and the thin film;
an electrode (4) formed on the thin film and;
an electrode (6) formed on the substrate.

2. A method of producing a Josephson device comprising of:
preparing a YBa₂Cu₃O₇₋ₓ(001)(0≦X≦0.6) c-axis oriented single crystal substrate (1);
heating the substrate up to 500°C to 680°C in vacuum;
depositing a thin YBa₂Cu₃O₇₋ₓ(001)(0≦X≦0.6) a-axis oriented single crystal thin film (2) on the heated single crystal substrate by a magnetron sputtering method such that a grain boundary is formed at the interface between the substrate (1) and thin film (2);
forming an electrode (4) on the thin film and;
forming an electrode (4) on the substrate.

## Patentansprüche

1. Josephsonanordnung, umfassend:
ein YBa₂Cu₃O₇₋ₓ(001)(0≤X≤0,6)-c-Achsen-orientierten-Einkristall-Substrat (1), das kein anderes Material außer YBa₂Cu₃O₇₋ₓ enthält;
einen YBa₂Cu₃O₇₋ₓ-a-Achsen-orientierten-Einkristalldünnfilm (2), der auf das Einkristall(001)-Substrat aufgebracht wurde, wobei (0≤X≤0,6),
eine Korngrenze (3), die an der Schnittstelle zwischen dem Substrat und dem Dünnfilm ausgebildet ist;
eine auf dem Dünnfilm ausgebildete Elektrode (4); und
eine auf dem Substrat ausgebildete Elektrode (6).

2. Verfahren zur Herstellung einer Josephsonanordnung umfassend folgende Schritte:
Vorbereiten eines YBa₂Cu₃O₇₋ₓ(001)(0≤X≤0,6)-c-Achsen-orientierten-Einkristall-Substrates (1);
Erhitzen des Substrates auf 500 °C bis 680 °C im Vakuum;
Aufbringen eines dünnen YBa₂Cu₃O₇₋ₓ(001)(0≤X≤0,6)-a-Achsen-orientierten-Einkristalldünnfilms (2) auf das erhitzte Einkristallsubstrat mittels eines Magneton-Sputtering-Verfahrens, so daß eine Korngrenze an der Schnittstelle zwischen dem Substrat (1) und dem Dünnfilm (2) gebildet wird;
Ausbilden einer Elektrode (4) auf dem Dünnfilm; und
Ausbilden einer Elektrode (6) auf dem Substrat.

## Revendications

1. Dispositif de Josephson comprenant :
un substrat (1) de monocristal orienté sur l'axe c, de formule YBa₂Cu₃O₇₋ₓ (001) (0 ≤ X ≤0,6), qui ne contient pas de matériau autre que YBa₂Cu₃O₇₋ₓ;
une mince couche (2) de monocristal orienté sur l'axe a, de formule YBa₂Cu₃O₇₋ₓ déposée sur le substrat de monocristal (001), dans laquelle (0 ≤ X ≤0,6);
une limite granulaire (3) formée à l'interface entre le substrat et la couche mince;
une électrode (4) formée sur la couche mince et;
une électrode (6) formée sur le substrat.

2. Procédé de production d'un dispositif de Josephson comprenant :
la préparation d'un substrat de monocristal (1) orienté sur l'axe c, de formule YBa₂Cu₃O₇₋ₓ (001) (0 ≤ X ≤ 0,6);
le chauffage du substrat jusqu'à une température de 500 à 680°C sous vide;
le dépôt d'une couche mince (2) de monocristal orienté sur l'axe a, de formule YBa₂Cu₃O₇₋ₓ (001) (0 ≤ X ≤ 0,6), sur le substrat de monocristal chauffé par un procédé de pulvérisation par magnétron de manière à former une limite granulaire à l'interface entre le substrat (1) et la couche mince (2);
la formation d'une électrode (4) sur la couche mince et;
la formation d'une électrode (4) sur le substrat.
